**Europäisches Patentamt**

**European Patent Office**

**Office européen des brevets**

(19)

(11) Veröffentlichungsnummer: **0 164 142 B1**

(12) **EUROPÄISCHE PATENTSCHRIFT**

(45) Veröffentlichungstag der Patentschrift: **27.03.91**

(51) Int. Cl.⁵: **G01N 24/08**

(21) Anmeldenummer: **85200644.4**

(22) Anmeldetag: **24.04.85**

(54) Verfahren und Anordnung zur Ermittlung einer Kernmagnetisierungsverteilung in einem Teil eines Körpers.

(30) Priorität: **02.05.84 NL 8401382**
        **18.09.84 NL 8402855**

(43) Veröffentlichungstag der Anmeldung:
**11.12.85 Patentblatt 85/50**

(45) Bekanntmachung des Hinweises auf die
Patenterteilung:
**27.03.91 Patentblatt 91/13**

(84) Benannte Vertragsstaaten:
**BE DE FR GB IT NL SE**

(56) Entgegenhaltungen:
**EP-A- 0 089 534**    **EP-A- 0 091 008**
**EP-A- 0 106 226**    **DE-A- 3 331 396**
**GB-A- 2 037 999**    **GB-A- 2 101 327**
**US-A- 3 975 675**    **US-A- 4 021 726**

(73) Patentinhaber: **N.V. Philips' Gloeilampenfabrieken**
**Groenewoudseweg 1**
**NL-5621 BA Eindhoven(NL)**

(72) Erfinder: **Kunz, Dietmar Wilhelm**
**p/a INT. OCTROOIBUREAU B.V. Prof. Holstlaan 6**
**NL-5656 AA Eindhoven(NL)**
Erfinder: **Tuithof, Hans Hermanus**
**p/a INT. OCTROOIBUREAU B.V. Prof. Holstlaan 6**
**NL-5656 AA Eindhoven(NL)**
Erfinder: **Cuppen, Johannes Josephus Maria**
**p/a INT. OCTROOIBUREAU B.V. Prof. Holstlaan 6**
**NL-5656 AA Eindhoven(NL)**

(74) Vertreter: **Faessen, Louis Marie Hubertus et al**
**INTERNATIONAAL OCTROOIBUREAU B.V. 6**
**Prof. Holstlaan**
**NL-5656 AA Eindhoven(NL)**

Rank Xerox (UK) Business Services

EP 0 164 142 B1

## Beschreibung

Die Erfindung betrifft ein Verfahren zur Ermittlung einer Kernmagnetisierungsverteilung in einem Teil eines Körpers, bei dem ein stationäres homogenes Magnetfeld erzeugt wird, in dem sich der Teil des Körpers befindet und bei dem

a) elektromagnetische Hochfrequenzimpulse zum Erzeugen eines Kernspinresonanzsignals erzeugt werden,

b) nach einer Vorbereitungszeit während einer Messzeit durch Abtastung eine Gruppe von Signalproben des Resonanzsignals genommen wird,

c) nach einer Wartezeit stets die Schritte a) und b) einige Male zum Erhalten verschiedener (n') Gruppen von je (n) Signalproben wiederholt werden, aus denen nach einer Signaltransformation ein Bild der erzeugten Kernmagetisierungsverteilung bestimmt wird, wobei die elektromagnetischen Hochfrequenzimpulse frequenzmodulierte Impulse sind.

Die Erfindung bezieht sich weiter auf ein Kernspinresonanzgerät das folgende Mittel enthält:

a) Mittel zum Erzeugen eines stationären homogenen Magnetfelds,

b) einen Hochfrequenzoszillator und eine Hochfrequenzspule zum Erzeugen elektromagnetischer frequenzmodulierter Hochfrequenzstrahlung, wobei die erzeugte Frequenz zeitabhängig ist,

c) Mittel zum Erzeugen eines Gradientenmagnetfeldes,

d) Abtastmittel zum Abtasten eines mit den under a) und b) erwähnten Mitteln erzeugten Resonanzsignals,

e) Verarbeitungsmittel zum Verarbeiten der von den Abtastmitteln gelieferten Gruppen von Signalproben, wobei ein Bild einer Kernmagnetisierungsverteilung bestimmt wird, und

f) Steuermittel zum Steuern der unter b) bis e) erwähnten Mittel zum Erzeugen, Konditinieren, Abtasten und Verarbeiten der Signalprobengruppen.

Ein Verfahren zum Ermitteln von NMR-Messwerte ist aus der US Patentschrift 3.975,675 bekannt. Die Messwerte geben ein Frequenzspektrum, das von einem chemischen Aufbau einer Substanz bestimmt wird. Ein dabei verwendeter Erregerpuls ist frequenzmoduliert, derart tadass der Frequenzbereich des Erregerpulses gleich oder grösser ist als den Frequenzbereich des erwarteten Spektrums. Dabei hat sich die Verwendung von frequenzmodulierten Erregerimpulsen als vorteilhaft erwiesen.

Aus der US Patentschrift 4,021,726 und aus der UK Patentanmeldung GB 2,101,327 sind NMR-Verfahren und Anordnungen bekannt womit Kernmagnetisierungsverteilungen ermittelt werden können. Dabei ist in den Schriften erwähnt, dass dabei frequenzmodulierte Hochfrequenzimpulse verwendet werden können. Es hat sich herausgestellt, dass bei Verwendung von frequenzmodulierten Hochfrequenzimpulsen die ermittelten Signale unterhalb der zu erwartenden Güte bleiben, so dass deshalb die ermittelte Kernmagnetisierungsverteilung dadurch nachteilig beeinflusst wurde.

Es ist die Aufgabe der Erfindung ein Verfahren und eine Anordnung zum Ermitteln von Kernmagnetisierungsverteilungen zu schaffen, wobei die Güte der erregten NMR-Signale und deshalb die Güte des herzustellenden Kernmagnetisierungverteilungsbildes wesentlich verbessert worden ist.

Ein Verfahren nach der Erfindung ist dadurch gekennzeichnet, dass die auf die Zeiteinheit bezogene Anderung der Frequenz der Hochfrequenzimpulse so gewählt ist, dass die von den einzelnen Hochfrequenzimpulsen bewirkten Phasenverschiebungen von Kernspins einander kompensieren, und falls bei jedem Hochfrequenzimpuls ein Gradientenmagnetfeld angelegt ist, dann die von den einzelnen Hochfrequenzimpulsen bewirkten Phasenverschiebungen von unterschiedlichen Gradientenmagnetfeldern ausgesetzten Kernspins einander kompensieren.

Die Erfindung basiert auf dem Gedanken, dass Kernspins, die an verschiedenen Stellen des Untersuchungsbereiches unterschiedlichen Magnetfeldern ausgesetzt sind, durch einen in der Frequenz modulierten Hochfrequenzimpuls unterschiedliche Phasendrehungen erfahren. Unterschiede können sich ungewollt aus der Inhomogenität des stationären Magnetfeldes und gewollt durch das Anlegen von magnetischen Gradientfeldern ergeben. Bei einem linear in der Frequenz modulierten Hochfrequenzimpuls ist genannte Phasendrehung umgekehrt proportional zur Geschwindigkeit, mit der sich die Frequenz ändert, d.h. zur Frequenzänderung pro Zeiteinheit. Diese Eigenschaft lässt sich in beanspruchter Weise zur Kompensation der die Auswertung des Echosignals beeinträchtigenden Phasenverschiebungen benutzen.

Da die Phasenverschiebung auch proportional zum Quadrat der Differenz der Kernspinresonanzfrequenzen an den verschiedenen Stellen des Untersuchungsbereiches und damit proportional zum Quadrat der Differenz der magnetischen Feldstärke an den betreffenden Stellen ist, sieht eine Weiterbildung der Erfindung, die bei Verfahren mit während der Hochfrequenzimpulse wirksamen magnetischen Gradientfeldern anwendbar ist, vor, dass die Feldstärke der während der Hochfrequenzimpulse wirksamen Gradientenfelder und/oder die auf die Zeiteinheit bezogenen Änderung der Frequenz der Hochfrequenzimpulse so

2

gewählt ist, dass die von den einzelnen Impulsen bewirkten Phasenverschiebungen der Kernspins einander kompensieren.

Wie dabei die Gradienten der magnetischen Gradientenfelder bzw. die Änderungen der Frequenz pro Zeiteinheit gewählt werden müssen, hängt von dem jeweiligen Untersuchungsverfahren ab. Bei einem Verfahren zum Aufnehmen von Spin-Echosignalen, wobei während eines 90°-Impulses ein magnetisches Gradientenfeld eingeschaltet und während eines 180°-Impulses ein in gleicher Richtung verlaufendes magnetisches Gradientenfeld wirksam ist, ist nach einer Weiterbildung der Erfindung vorgesehen, dass die Gradientenfelder bzw. die Frequenzänderungen pro Zeiteinheit so gewählt sind, dass die Beziehung

$$g_1^2 \ / \ \beta_1 \ = \ 2g_2^2 \ / \ \beta_2$$

erfüllt ist, wobei $g_1$, $g_2$ dem Gradienten des magnetischen Gradientenfeldes während des ersten bzw. des zweiten Hochfrequenzimpulses und $\beta_1$, $\beta_2$ die auf die Zeiteinheit bezogenen Frequenzänderungen während des ersten bzw. zweiten Hochfrequenzimpulses sind.

Anders liegen jedoch die Verhältnisse, wenn ein sogenanntes stimuliertes Echo (stimulated echo) aufgenommen werden soll. Bei diesem aus den Aufsätzen von E.L. Hahn in "Physical Review" 80, 4, Nov. 15, 1950 p. 580 ff und J.E. Tanner in "The Journal of Chemical Physics" 52, Nr. 5, 1. März 1970, p. 2523-2526 bekannten Verfahren werden aufeinanderfolgend drei Hochfrequenzimpulse erzeugt, von denen zumindest die beiden ersten vorzugsweise 90°-Impulse sind. Das stimulierte Echosignal erreicht dann sein Maximum zu einem Zeitpunkt nach dem dritten Hochfrequenzimpuls, der dem zeitlichen Abstand der beiden ersten Hochfrequenzimpulse entspricht. Bei einem derartigen Verfahren lassen sich die geschilderten unerwünschten Phasenverschiebungen dadurch beseitigen, dass die Gradientenfelder und die Frequenzmodulation der Impulse so gewählt sind, dass die Beziehung

$$g_1^2 \ / \ \beta_1 \ = \ g_2^2 \ / \ \beta_2 \ + \ g_3^2 \ / \ \beta_3$$

erfüllt ist, wobei $g_1$, $g_2$, $g_3$ den Gradienten des magnetischen Gradientenfeldes während des ersten, zweiten bzw. dritten Hochfrequenzimpulses und $\beta_1$, $\beta_1$, $\beta_3$ den auf die Zeiteinheit bezogenen Änderungen der Frequenz während des ersten, zweiten bzw. dritten Hochfrequenzimpulses entsprechen.

Ein erfindungsgemässes Kernspinresonanzgerät zur Durchführung des Verfahrens nach Anspruch 1 ist gekennzeichnet durch programmierte Mittel zum Einstellen der auf die Zeiteinheit bezogenen Änderung der Frequenz der nacheinanderfolgenden Hochfrequenzimpulse und/oder der Stärke des gegebenenfalls während der Hochfrequenzimpulse vorhandenen Gradientenmagnetfeldes zur Kompensation der von den einzelnen Hochfrequenzimpulsen bewirkten Phasenverschiebungen von Kernspins.

Durch die Anordnung nach der Erfindung wird ein stärkeres, sauberes NMR-Signal erzeugt, und deshalb wird eine höhere Bildgüte der rekonstruierten Kernmagnetisierungsverteilung entstehen.

Ausführungsbeispiele der Erfindung werden nachstehend anhand der Zeichnung näher erläutert. Es zeigen

Fig. 1 ein Spulensystem als Teil einer erfindungsgemässen Anordnung,

Fig. 2 eine Anordnung zur Durchführung des erfindungsgemässen Verfahrens,

Fig. 3 eine Ausführungsform eines Hochfrequenzoszillators für eine erfindungsgemässe Anordnung,

Fig. 4 eine weitere Ausführungsform eines Hochfrequenzoszillators für eine erfindungsgemässe Anordnung, und

Fig. 5 eine bevorzugte Ausführungsform eines Hochfrequenzoszillators für eine erfindungsgemässe Anordnung.

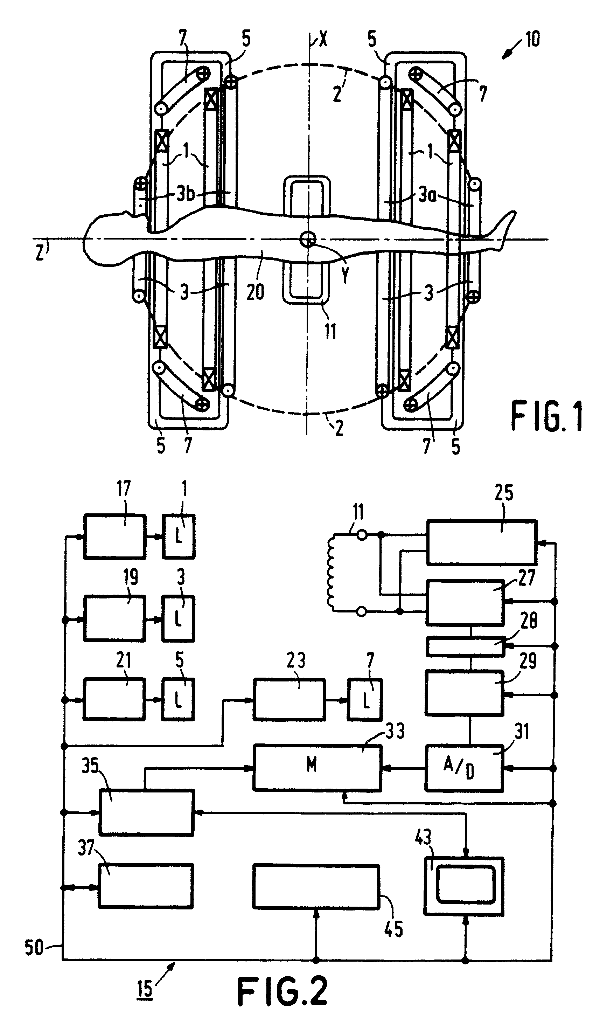

In Fig. 1 ist ein Spulensystem 10 dargestellt, das ein Teil einer Anordnung ist, die zur Ermittlung einer Kernmagnetisierungsverteilung in einem Teil eines Körpers 20 ist. Der Teil hat beispielsweise eine Dicke $\Delta z$ und liegt in der x-y-Ebene des dargestellten Koordinatensystems (x, y, z). Die y-Achse des Systems verläuft dabei senkrecht zur Zeichenebene nach oben. Mit dem Spulensystem 10 werden ein einheitliches stationäres Magnetfeld parallel zur z-Achse, drei Gradientenmagnetfelder $G_x$, $G_y$ und $G_z$ mit einer Feldrichtung parallel zur z-Achse und mit einer Gradientenrichtung parallel zur x-, y- bzw. z-Achse und ein Hochfrequenzmagnetfeld erzeugt. Das Spulensystem 10 enthält dazu einige Hauptspulen 1 zum Erzeugen des stationären einheitlichen Hauptmagnetfels Bo mit einer Stärke zwischen 0,2 und 2 Tesla. Die Hauptspulen 1 können beispielsweise auf der Oberfläche einer Kugel 2 angeordnet sein, deren Mitte im Ursprung 0 des dargestellten karthesischen Koordinatensystems (x, y, z) liegt, wobei die Achsen der Hauptspulen 1 mit der z-Achse zusammenfallen.

Weiter enthält das Spulensystem 10 beispielsweise vier auf derselben Kugeloberfläche angeordnete Spulen $3_a$, $3_b$, mit denen das Gradientenmagnetfeld $G_z$ erzeugt wird. Ein erster Satz 3a wird dazu in entgegengesetztem Sinne in bezug auf den Durchfluss des zweiten Satzes 3b mit einem Strom erregt, der in der Figur mit ⊙ und ⊗ angegeben ist. Dabei bezeichnet ⊙ einen in den Querschnitt der Spule 3 hineinfliessenden Strom und ⊗ eine aus dem Querschnitt der Spule herausfliessenden Strom.

Das Spulensystem 10 enthält beispielsweise vier Rechteckspulen 5 (von denen nur zwei dargestellt sind) oder vier andere Spulen, wie beispielsweise "Golay-Spulen" zum Erzeugen des Gradientenmagnetfeldes $G_y$. Zum Erzeugen des Gradientenmagnetfeldes $G_x$ dienen vier Spulen 7 mit der gleichen Form wie die Spulen 5 die über einen Winkel von 90° um die z-Achse in bezug auf die Spulen 5 verdreht sind. In Fig. 1 ist weiter noch eine Spule 11 dargestellt, mit der ein hochfrequentes elektromagnetisches Feld erzeugt und detektiert werden kann.

In Fig. 2 ist eine Anordnung 15 zum Durchführen eines erfindungsgemässen Verfahrens dargestellt. Die Anordnung 15 enthält Spulen 1, 3, 5, 7 und 11, die anhand der Fig. 1 bereits beschrieben wurden, Stromgeber 17, 19, 21 bzw. 23 zum Erregen der Spulen 1, 3, 5 bzw. 7 und einen Hochfrequenzsignalgeber 25 zum Erregen der Spule 11. Die Anordnung 15 enthält weiter einen Hochfrequenzsignaldetektor 27, einen Demodulator 28, eine Abtastschaltung 29, Verarbeitungsmittel, wie z.B. einen Analog/Digital-Wandler 31, einen Speicher 33 und einen Rechner 35 zur Durchführung einer Signaltransformation (beispielsweise eine Fourier-Transformation), eine Steuereinheit 37 zum Steuern der Abtastzeitpunkte und weiter eine Wiedergabeanordnung 43 und zentrale Steuermittel 45, deren Funktionen und gegenseitige Zusammenhänge weiter unten näher erläutert werden.

Mit der beschriebenen Anordnung 15 wird ein Verfahren zur Ermittlung der Kernmagnetisierungsverteilung in einem Körper 20 nach obiger Beschreibung durchgeführt. Das Verfahren umfasst mehrere Schritte. Vor der Ermittlung werden die im Körper vorhandenen Kernspins zur Resonanz angeregt. Die Resonanzanregung der Kernspins erfolgt durch das Einschalten des Stromgebers 17 aus der zentralen Steuereinheit 45, wodurch die Spule 1 erregt wird. Hierdurch wird ein stationäres und homogenes Magnetfeld Bo erzeugt. Weiter wird der Hochfrequenzgeber 25 kurze Zeit eingeschaltet, so dass die Spule 11 ein hochfrequentes elektromagnetisches Feld erzeugt (Hf-Feld). Durch die angelegten Magnetfelder können die Kernspins im Körper 20 angeregt werden, wobei die angeregte Kernmagnetisierung einen bestimmten Winkel, beispielsweise 90° (90° Hf-Puls), mit dem homogenen Magnetfeld Bo bildet. An welcher Stelle und welche Kernspins angeregt werden, ist u.a. von der Stärke des Feldes Bo, von einem ggf. anzulegenden Gradientenmagnetfeld und von der Kreisfrequenz $\omega$ des hochfrequenten elektromagnetischen Feldes abhängig, weil die Gleichung $\omega = \gamma \cdot Bo$ erfüllt werden muss, worin $\gamma$ das gyromagnetische Verhältnis ist (für freie Protonen, beispielsweise $H_2O$ Protonen beträgt $\gamma/2_\pi$ = 42,576 MHz/T). Nach einer Anregungszeit wird der Hochfrequenzgeber 25 von den zentralen Steuermitteln 45 ausgeschaltet. Die Resonanzanregung erfolgt jeweils beim Beginn jedes Messzyklus. Für manche Ausführungsformen werden auch im Messzyklus Hf-Impulse in den Körper eingeführt. Diese Hf-Pulse sind dabei z.B. 180° Hf-Pulse, die periodisch in den Körper eingegeben werden. In diesem letzten Beispiel ist die Rede von "spin-echo". Spin-Echo ist u.a. in der Veröffentlichung von I.L. Pykett "NMR Imaging in Bedicine", Scientific American, Mai 1082, beschrieben.

In einem folgenden Schritt werden Abtastsignale gesammelt, wobei je nach Art der Messung (beispielsweise Kernspindichteverteilung, Stromgeschwindigkeitsverteilung, ortsabhängige Spektroskopie) möglicherweise die Gradientenfelder verwendet werden, die die Geber 19 bzw. 21, 23 unter der Steuerung der zentralen Steuermittel 45 erzeugt werden. Die Detektion des Resonanzsignals (mit FID-Signal bezeichnet) erfolgt durch das Einschalten des Hochfrequenzdetektors 27, des Demodulators 28, der Abtastschaltung 29, des Analog/Digital-Wandlers 31 und der Steuereinheit 37. Dieses FID-Signal wird dadurch hervorgerufen, dass durch den Hf-Anregungsimpuls die Kernmagnetisierung um die Feldrichtung des Magnetfeldes Bo präzedieren. Diese Kernmagnetisierung führt in die Detektorspule eine Induktionsspannung ein, deren Amplitude ein Mass für die Kernmagnetisierung ist.

Die aus der Abtastschaltung 29 herrührenden analogen abgetasteten FID-Signale werden in digitale Signale (Wandler 31) umgesetzt und so in einen Speicher 33 eingeschrieben. Nach Ablauf der Ermittlungszeit stoppen die zentralen Steuermittel 45 die Geber 19, 21 und 23, die Abtastschaltung 29, die Steuereinheit 37 und den Analog/Digital-Wandler 31. Die abgetasteten FID-Signale sind im Speicher 33 gespeichert und werden über Fourier-Transformation in ein Bild der erzeugten Kernmagnetisierungsverteilung in jenem Teil des Körpers umgesetzt, in dem die Kernspins auf geeignete Weise angeregt sind. In welchem Teil des Körpers Kernspins angeregt sind, wird vom angelegten Magnetfeld (das Hauptfeld Bo und ein Gradientenmagnetfeld G) und von der (den) Frequenz(en) des Hochfrequenzimpulses bestimmt. Es gilt dabei, dass $\omega = \gamma (Bo + G_z \cdot z)$ (bei einem Gradientenmagnetfeld in der z-Richtung) oder auch $z = (\omega - \gamma \cdot Bo)/(\gamma \cdot G_z)$. Ist die Bandbreite des Hf-Impulses $\Delta\omega$, so gilt $\Delta z = \Delta\omega/\gamma \cdot G_z$. Ist $\omega_0$ die zentrale Frequenz

EP 0 164 142 B1

im Spektrum des Hf-Impulses, werden Kernspins in einer "Scheibe" mit der Dicke $\Delta z$ angeregt, die symmetrisch die zentrale Fläche $z = (\omega_0 - \gamma . Bo)/(\gamma.G_z)$ umfasst. Hat das Hauptfeld Bo eine Stärke von 2 T und eine Homogenität von 25 ppm (Teile je Million) dann ergibt eine Gradientenmagnetfeldstärke von 5 mT/m und eine Beschränkung der geometrischen Verzerrung auf 1 cm. Zum Anregen einer Scheibe $\Delta z$ von 1 cm Dicke ist ein Hf-Impuls mit einer Bandbreite von 2 kHz bei der gegebenen Gradientenmagnetfeldstärke erforderlich. Bei der Verwendung dreidimensionaler Fourier-Kernspintomographie (bei der ein dreidimensionales Bild erhalten wird), müssen dickere Scheiben angeregt werden. So ist für eine 10 cm dicke Scheibe ein Hf-Impuls mit einer Bandbreite von 20 kHz erforderlich. Nach dem Stand der Technik wäre dazu ein Hochfrequenzgeber erforderlich, der eine hundertfache Spitzenleistung liefern müsste. Dies wird nachstehend näher erläutert: Die Fourier-Transformierte eines Impulses p(t) ist $F(p(t)) = P(\omega)$. Die Vergrösserung der Bandbreite um den Faktor a ist die Verringerung der Frequenzskala um den Faktor a gleichwertig, so dass die Fourier-Transformierte als $p(\omega/a)$ statt $P(\omega)$ geschrieben werden kann. Die Fourier-Rücktransformierte ist $F(p(\omega/a)) = \int a \int .p(at)$ . Es entsteht also eine Zusammenziehung des Impulses im Zeitbereich um den Faktor a und eine Vergrösserung der Amplitude des Impulses um den gleichen Faktor.

Bei einem frequenzmodulierten Hf-Impuls muss der Hochfrequenzgeber in obigem Beispiel nur eine zehnfache Spitzenleistung abgeben können. Auch ist ersichtlich, dass vorzugsweise die Frequenz linear zeitabhängig ist. Die momentane Frequenz des Hf-Impulses beträgt $\omega(t) = \omega + \beta.t$ ($\omega_0$, $\beta$ sind Konstanten), so dass die Phase des Hf-Impulses gleich

$$\emptyset(t) = \omega_0 . (t-t_0) + \tfrac{1}{2} \beta (t^2 - t_0^2)$$

ist. Schwankt die Frequenz des Hf-Impulses um die Larmorfrequenz ($\omega_0 = \gamma.Bo$) des Systems, beträgt die Phase in einem mit der Kreisfrequenz $\omega_0$ mitdrehenden Koordinatensystem

$$\emptyset(t) = \tfrac{1}{2} . \beta (t^2 - t_0^2).$$

Wird die Phase bei $t = t_0$ gleich O gemacht, so dass $\emptyset(t) = \tfrac{1}{2} \beta t^2$, müsste ein Hf-Impuls die Konfiguration $S(t) = A . \exp(\tfrac{1}{2} i \beta t^2)$ haben können, wobei die Amplitude A konstant ist. Die Fourier-Transformierte von S(t) ist $S(\omega) = A \sqrt{i/\beta}. \exp(-i\omega^2/2\beta)$ die ein Frequenzspektrum von $-\infty$ bis $+\infty$ hat. Wird für $S(\omega)$ eine Rechteckform gewählt, ist die Zeitfunktion S(t) eine "sin(x)/x-artige" ' Funktion, die im Zeitbereich von $-\infty$ bis $+\infty$ verläuft. Für das Frequenzspektrum $S(\omega)$ wird vorzugsweise eine Rechteckform genommen, wobei die Flanken durch Gaus'sche Kurven gebildet werden. Das Zeitsignal ist dabei ein rechteckartiger Impuls, bei dem die Vorderflanke exponentiell ansteigt, das Signal über eine abklingende Schwingung einen Endwert erreicht und die Rückflanke die gespiegelte Form der Vorderflanke ist. Obige Form ist nur eine der verschiedenen Signalformen, die verwendet werden können und der Bedingung erfüllen, dass sie sowohl im Zeit- als auch im Frequenzbereich scharf abgegrenzt sind. Die Signalformen lassen sich wie folgt bestimmen:

a) die erforderliche Bandbreite $\Delta\omega$ aus der gewünschten Scheibendicke und aus der Gradientenmagnetfeldstärke berechnen (für die selektive Anregung). Bei der Abbildung von Wasserstoffprotondicken (bei 80 MHz) betragen die Bandbreiten 500 Hz bis 50 kHz.

b) die Impulsdauer wählen (beispielsweise 1 bis 10 ms). Je länger die gewählte Impulsdauer, um so niedriger wird die erforderliche Spitzenleistung sein. Jedoch macht sich bei einer zu langen Impulsdauer der Einfluss der T2-Relaxationszeit bemerkbar.

c) Aus der Bandbreite und der Impulsdauer die Frequenzänderungsgeschwindigkeit $\beta$ bestimmen (bei der Verwendung von Kernspinechotechnik ist $\beta$ für die 180°-Impulse etwa zweimal höher in bezug auf das $\beta$ für die 90°-Impulse, wie weiter unten näher erläutert wird).

d) eine Funktion (Umhüllende) des Frequenzspektrums wählen, wie

$$f(\omega) = \begin{cases} 1 & \omega - \omega_0 \leq \Delta\omega \\ \exp(-\tfrac{1}{2}(|\omega - \omega_0| - \Delta\omega)^2/b^2) & \text{für} \quad \omega - \omega_0 > \Delta\omega \end{cases}$$

wobei beispielsweise $\Delta\omega = 2 . \pi. 10$ kHz und $b = 2\pi . 500$ Hz.

e) Das komplexe Zeitsignal aus obigen Daten berechnen und damit den frequenzmodulierten Oszillator steuern.

5

f) Die Grösse des Hf-Impulses derart einstellen, dass in dem mit der Winkelfrequenz $\omega_0$ drehenden Koordinatensystem für ein magnetisches Hf-Feld $B_1(x')_t$ und $B_2(y')_t$ die Gleichungen

$\int\gamma \cdot (B_1(x')_t + iB_2(y')_t \, dt = \pi/2$ für eined 90°-Impuls und

$\int\gamma \cdot (B_2(x')_t + iB_2(y')_t \, dt \approx 1,3\pi$ für einen 180°-Impuls, erfüllt sind, wobei $\gamma$ das gyromagnetische Verhältnis ist.

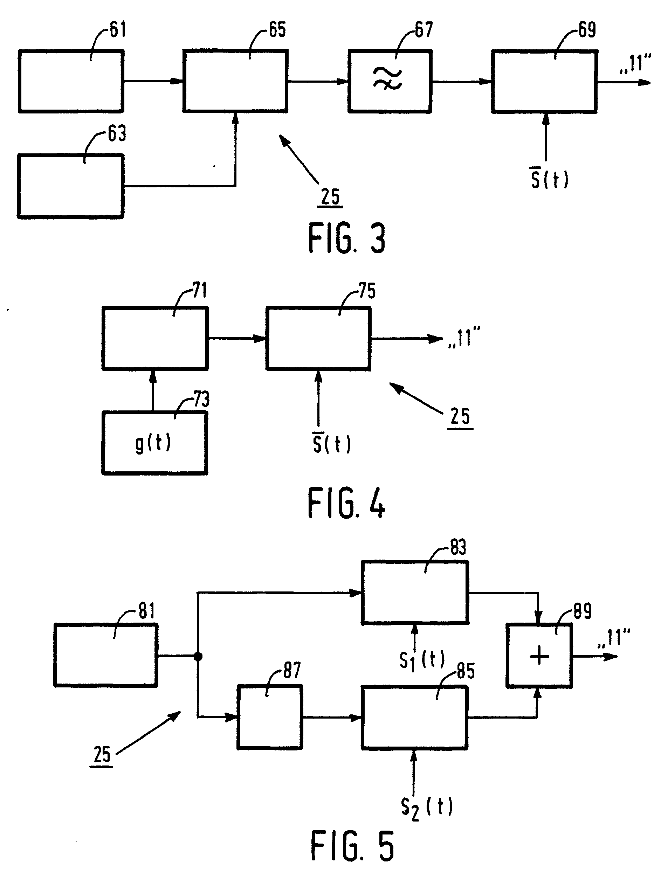

In Fig. 3 ist ein erstes Ausführungsbeispiel eines Hochfrequenzoszillators 25 (Geber) für eine Anordnung 15 nach der Erfindung dargestellt. Der Oszillator 25 enthält einen Konstantfrequenzoszillator 61, einen Niederfrequenzoszillator 63, einen Amplitudenmodulator 65, ein Frequenzfilter 67 und einen weiteren Amplitudenmodulator 69. Das vom Oszillator 61 erzeugte Signal mit der Frequenz $f_0$ wird zusammen mit dem vom Oszillator 63 erzeugten Signal f, dessen Frequenz (vorzugsweise linear) von $f_1$ bis $f_2$ ansteigt, dem Modulator 65 zugeführt. Der Modulator 65 erzeugt bekanntlich ein Ausgangssignal, das Signale mit der Summenfrequenz $f_0 + f$ (oberes Band) und mit der Differenzfrequenz $f_0 - f$ (unteres Band) enthält. Eines der Signale wird vom Filter 67 durchgelassen. Das Filter 67 lässt daher entweder die Frequenzen über $f_0$ oder die Frequenzen unter $f_0$ durch. Das Ausgangssignal des Filters 67 gelangt über einen Amplitudenmodulator 69 (beispielsweise einen regelbaren Verstärker) an die Hochfrequenzspule 11 (Fig. 1 und 2).

Die Änderung der Frequenz von $f_1$ bis $f_2$ bestimmt die Bandbreite der erzeugten Hf-Signals. Der Modulator 65 (der beispielsweise auch ein Vierquadrantmultiplizierer sein kann) erzeugt ein Hf-Signal mit konstanter Amplitude, die vom Modulator 69 mit dem Zeitsignal $\bar{s}(t)$ (der Um hüllenden des HF-Impulses) multipliziert wird. Dieses Zeitsignal wird durch

$$\bar{s}(t) = \sqrt{s_1^2(t) + s_2^2(t)}$$

bestimmt, wobei $s_1(t)$, $s_2(t)$ die reellen bzw. imaginären Signale der Fourier-Transformierten der im Frequenzspektrum gewählten Funktion sind. Selbstverständlich muss sich das Zeitsignal $\bar{s}(t)$ synchron mit der Frequenzänderung (Oszillator 63) ändern.

In Fig. 4 ist eine weitere Ausführungsform eines Hochfrequenzoszillators 25 für eine erfindungsgemässe Anordnung 15 dargestellt. Der Hochfrequenzoszillator 25 enthält einen spannungsgesteuerten Oszillator 71, der von einem Spannungsfunktionsgeber 73 gesteuert wird. Ist die vom Oszillator 71 erzeugte Frequenz von der Steuerspannung linear abhängig, erzeugt der Funktionsgeber 73 eine Dreieckspannung, die selbstverständlich mit dem Zeitsignal $\bar{s}(t)$ synchronisiert werden muss, mit dem ein Amplitudenmodulator 75 zur Bildung des verlangten Hf-Impulses gesteuert wird. Der Ausgang des Amplitudenmodulators 75 ist mit der Hochfrequenzspule 11 verbunden.

In Fig. 5 ist eine bevorzugte Ausführungsform eines Hochfrequenzoszillators 25 für eine Anordnung 15 (Fig. 1 und 2) nach der Erfindung dargestellt. Der Hochfrequenzoszillator 25 enthält einen Konstantfrequenzoszillator 81 und einen Quadraturmodulator, der einen 90°-Phasendreher 87, zwei Amplitudenmodulatoren 83 und 85 sowie eine Addierschaltung 89 enthält. Das im Oszillator 81 erzeugte Hochfrequenzsignal (cos $\omega t$) gelangt über den 90°-Phasendreher 87 zum Amplitudenmodulator 85. Die Amplitudenmodulatoren 83 und 85 empfangen die Zeitsignale $s_1(t)$ bzw. $s_2(t)$, wobei $s_1(t)$ und $s_2(t)$ die reellen bzw. imaginären Zeitsignale der Fourier-Transformierten der im Frequenzspektrum gewählten Funktion sind. Die Addierschaltung 89, die in diesem Fall nur einen Differenzverstärker zu erhalten braucht, empfängt die Ausgangssignale der zwei Modulatoren 83 und 85 und fügt die zwei Signale zusammen. Das Ausgangssignal der Addierschaltung 89 ist gleich

$S(t) = s_1 \cos\omega t - s_2(t) \sin\omega t.$
$\quad\quad = \mathrm{Re}((s_1(t) + is_2(t)) \exp i \, \omega t)$

und gelangt an die Hochfrequenzspule 11.

Bei der Verwendung frequenzmodulierter Anregungsimpulse (90° Impulse und/oder 180° Echoimpulse) ergibt sich, dass die angeregten Kernspins untereinander eine Phasendifferenz aufweisen, die quadratisch von der örtlichen Winkelfrequenz $\Delta\omega$ abhängig ist, wie weiter unten näher erläutert wird. Insbesondere bei selektiver Anregung ist diese Erscheinung stark störend, weil sie in einer Richtung quer zur ausgewählten Schicht auftritt. Die quadratische Abhängigkeit der Phasenunterschiede vom Abstand zu einer zentralen Fläche in einer ausgewählten Schicht macht ein von den so angeregten Kernspins erzeugtes Resonanzsignal (FID- oder Spin-Echosignal) zur Verwendung für die Bildformung der Kernmagnetisierungsverteilung in der angeregten Schicht ungeeignet.

Die obige Erscheinung lässt sich wie folgt begreifen. Ein FM-Impuls (90°- oder 180°-Impuls), wie er für Anregung benutzt wird, wird mit Hilfe eines Hf-Signals verwirklicht, dessen Kreisfrequenz sich linear zeitabhängig von $\omega_0 - \Delta\omega$ bis $\omega_0 + \Delta\omega$ während der Impulsdauer von $-\Delta t$ bis $+\Delta t$ ändert. Die Art des FM-Impulses ist jedoch derart, dass ein Kernspin, der auf der Kreisfrequenz $\omega_1$ in Resonanz ist (beispielsweise durch ein Gradientenfeld oder durch Hauptfeldinhomogenität), nur eine sehr kurze Zeit ($t_1 - \epsilon_t$ bis $t_1 + \epsilon_t$) wirksam beeinflusst wird. Dies ist der Fall, wenn die Kreisfrequenz $\omega$ der FM die genannte Kreisfrequenz $\omega_1$ des Kernspins durchläuft. Die Dauer $2 \epsilon_t$ ist viel kleiner als die ganze Impulsdauer $2 \Delta t$ , daher sei angenommen, dass in diesem Falle der Kernspin bei der Kreisfrequenz $\omega_1$ des FM-Impulses und genau zum zugeordneten Zeitpunkt $t_1$ die bezweckte $90°$ oder $180°$ in der Orientierungsrichtung umklappen. Zwei Auswirkungen haben die Phase der Kernspins am Ende des FM-Impulses beeinflusst:

a die Phase des FM-Impulses selbst zum Zeitpunkt von $t_1$ und

b̄ der Zeitpunkt $t_1$, zu dem die Kernspins umklappen.

Der Effekt a bedeutet, dass bei einem $90°$-Impuls die Kernspins (von der z-Achse) mit einem bestimmten Phasenwinkel in der x-y-Ebene gedreht werden, und dass bei einem $180°$-Impuls die Kernspins in bezug auf eine Linie mit einer bestimmten Phase gespiegelt werden. Es sei angenommen, dass das FM-Signal folgende Form hat:

$\cos(\omega_0 t + \beta t^2)$ für $- \Delta t < t < \Delta t$.

Für die Kreisfrequenzänderungsgeschwindigkeit $\beta$ gilt:

$\beta = \Delta\omega / 2 \Delta t$.

Wird zum Zeitpunkt $t_1$ die Winkelfrequenz $\omega_1$ erreicht, so gilt:

$\omega_1 = \omega_0 + 2\beta t_1$ und

$t_1 = (\omega_1 - \omega_0)/2\beta$.

Wird eine Zeitdifferenz $\tau$ in bezug auf den Zeitpunkt $t_1$ genommen, (so dass $t = t_1 + \tau$ ist), so gilt:

$\cos(\omega_0 t + \beta t^2) = \cos(\omega_1 \tau + \beta\tau^2 + \omega_0 t_1 + \beta t_1 2)$.

Daraus ist ersichtlich, dass in einem sich (mit der Kreisfrequenz $\omega_0$) drehenden System der von den bei der Kreisfrequenz $\omega$ in Resonanz befindlichen Kernspins erfahrene Impuls eine Phasenverschiebung $\phi\omega^{(1)}$ in bezug auf den Impuls hat, der die mit einer Winkelfrequenz $\omega_0$ resonierenden Kernspins beeinflusst, welche Phasenverschiebung folgende Grösse hat:

$\phi\omega^{(1)} = (\omega - \omega_0)^2/4\beta$.

Der Effekt b wird vom Auswahlgradientenfeld bewirkt, das meist bei $90°$- oder $180°$-Impulsen zum selektiven Anregen von Kernspins in einer Schicht in einem Körper vorhanden ist, und das Kreisfrequenzdifferenzen für verschiedene Kernspins induziert und die während einer Zeit von $t_0$ bis $t_2$ anliegt. Ein mit der Kreisfrequenz $\omega_1$ präzedierender Kernspin erfährt also das Gradientenfeld eine Zeit $t_1 - t_0$, bevor der Kernspin umklappt, und eine Zeit $t_2 - t_1$ nachdem der Kernspin umgeklappt ist. Bei einem $90°$ Impuls erfährt der Kernspin kein Gradientenfeld - jedoch während des Zeitraums $t_2 - t_1$, wodurch eine Phasenverschiebung $\phi^{(2)}$ bewirkt wird (in bezug auf Kernspins, die mit der Kreisfrequenz $\omega_0$ präzedieren):

$\phi^{(2)} = (t_2 - t_1) (\omega_1 - \omega_0)$

$= t_2 (\omega_1 - \omega_0) - (\omega_1 - \omega_0)^2/2\beta$.

Die gesamte Dephasierung bei einem $90°$-Impuls für einen Kernspin, der mit einer Winkelfrequenz $\omega_1$ präzediert, ist also gleich inem linearen Term plus

$$\phi_\omega(90) = - \frac{(\omega_1 - \omega_0)^2}{4\beta} \; .$$

Für einen $180°$-Impuls gilt folgendes: die Phase des $180°$-Impulses selbst ist zum Zeitpunkt $t_1$ gleich $\phi\omega_1 = (\omega_1 - \omega_0)^2/4\beta$ , was auch die Phase oder der Winkel der Spiegellinie in der x-y-Ebene darstellt, in bezug auf welche Ebene die Kernspins vom $180°$-Impuls gespiegelt werden. Dieser Winkel, wenn er ungleich Null ist, bewirkt eine zusätzliche Phasenverschiebung in der Phase der Kernspins mit der zweifachen Grösse dieses Winkels. Daher ist die Dephasierung von einem $180°$-Impuls durch folgendes bestimmt:

$$\phi_\omega(180) = \frac{-(\omega_1 - \omega_0)^2}{2\beta}$$

Die gleiche Begründung lässt sich selbstverständlich auf die Frequenzverschiebung durch (Haupt-) Feldinhomogenitäten anwenden.

Eine nähere Betrachtung der quadratischen Terme

$$\varphi_\omega(90) = \frac{-(\omega - \omega_0)^2}{4\beta} \quad \text{und} \quad \varphi_\omega(180) = \frac{-(\omega - \omega_0)^2}{2\beta}$$

und unter Berücksichtigung der Tatsache, dass der Beitrag des Termes $\phi\omega^{(90)}$ an der Phase der Kernspins von einem 180°-Impuls invertiert wird, führt zur Schlussfolgerung, dass die quadratischen Terme einander beseitigen, wenn die Kreisfrequenzänderungsgeschwindigkeit $\beta_{180}$ eines 180°-Impulses zweimal grösser als die Kreisfrequenzänderungsgeschwindigkeit $\beta$ des 90°-Impulses ist. Eine weitere Art der gegenseitigen Kompensation der quadratischen Terme $\phi\omega_1^{(90)}$ und $\phi\omega^{(180)}$ unter Verwendung selektiver Gradientenfelder besteht darin, die Gradientenfeldstärke während des 180°-Impulses um einen Faktor $\sqrt{2}$ kleiner als die Gradientenfeldstärke während des 90° − Impulses zu machen.

Obgleich beide Verfahren wirken, können nur die ungeradzahligen Echosignale für die Bildrekonstruktion benutzt werden, weil die vom 90°-Impuls erzeugte quadratische Abhänigkeit vom ersten 180°-Impuls ausgeglichen wird, und die von einem zweiten (2 . n$^e$) 180°-Impuls erzeugte quadratische Abhängigkeit erst vom dritten (2 . n+1$^e$) 180°-Impuls behoben wird. Nachstehend wird eine Lösung für das oben erwähnte Problem gegeben, bei der ein zusammengesetzter 180°-FM-Impuls verwendet wird. Ein optimaler 180°-Impuls in einer Zentrierung um den Zeitpunkt $\tau$ macht alle Kernspins, die zum Zeitpunkt t = 0 phasengleich sind, wieder zum Zeitpunkt $2\tau$ phasengleich. Es wird eine Sequenz von drei aufeinanderfolgenden 180°-FM-Impulse beschrieben (I, II und III), von denen der mittlere Impuls II die halbe Kreisfrequenzänderungsgeschwindigkeit in bezug auf die Kreisfrequenzänderungsgeschwindigkeit der Impulse I und III, eine zweimal längere Dauer und eine Amplitude hat, die die Hälfte der Amplitude der Impulse I und III ist. Unter Verwendung der oben dafür gegebenen Formel für die Dephasierung vom 180°-Impuls ist ersichtlich, dass die gesamte dephasierende Wirkung des zusammengesetzten 180°-Impulses eine quadratische Komponente gleich Null hat. Der quadratische Beitrag des Impulses I wird (von den Impulsen I und III) zweimal und der quadratische Beitrag des Impulses II einmal invertiert. Die Gesamtauswirkung der quadratischen Beiträge ist daher:

$$\gamma\omega\text{comb.} \quad = \gamma\omega^I - \gamma\omega^{II} + \gamma\omega^{III}$$
$$= -(\omega - \omega_0)^2/2\beta + (\omega - \omega_0)^2/\beta - (\omega - \omega_0)^2/2\beta = 0.$$

Es ist klar, dass jetzt alle Echosignale für die Bildrekonstruktion verwendet werden können, wobei der zusammengesetzte 180° − FM-Impuls viel kürzer als die Zeit ist, die ncrmalerweise zum Erzeugen eines unbrauchbaren und eines folgenden brauchbaren Echosignals erforderlich wäre. Weiter ist ersichtlich, dass ebenfalls aus fünf, sieben, usw. 180°-Impulsen zusammengesetzte Impulse gebildet werden können, für die die Summe der quadratischen Beiträge zur Dephasierung der Kernspins gleich Null ist. Jedoch erfordern derartige zusammengesetzt 180°-Impulse mehr Energie und haben eine grössere Verlustleistung in einem zu untersuchenden Objekt, was sich in dem Falle, wenn das Objekt ein Patient oder ein Tier ist, unerwünscht ist.

Wenn nach drei aufeinanderfolgenden, zeitlich linear in der Frequenz modulierten Hochfrequenzimpulsen ein sogenanntes stimuliertes Echosignal empfangen werden soll, muss die Beziehung

$$g_1^2/\beta_1 = g_2^2/\beta_2 + g_3^2/\beta_3 \qquad\qquad (1)$$

erfüllt sein, wenn die unerwünschten Phasenverschiebungen zwischen Kernspins an unterschiedlichen Orten des Untersuchungsbereiches vermieden werden sollen. Dabei sind $g_1$, $g_2$, $g_3$ die Gradienten der magnetischen Gradientenfelder während des ersten, des zweiten bzw. des dritten Hochfrequenzimpulses und $\beta_1$, $\beta_2$, $\beta_3$ die auf die Zeiteinheit bezogene Frequenzänderung im ersten, zweiten bzw. dritten Hochfrequenzimpuls. Dabei lässt sich die Kompensation auf verschiedene Weise erreichen. Beispielsweise ergibt sie sich, wenn die Frequenzänderung des zweiten und des dritten Impulses doppelt so gross ist wie die Frequenzänderung des ersten Impulses. Eine andere Möglichkeit sieht vor, dass der Gradient des magnetischen Gradientenfeldes während des ersten Hochfrequenzimpulses um den Faktor $\sqrt{2}$ grösser ist als der Gradient sowohl beim zweiten als auch beim dritten Hochfrequenzimpuls.

Schliesslich ist es möglich, einen der drei Impulse in der Amplitude zu modulieren und nur die beiden anderen zeitlich linear in der Frequenz. Dies bedeutet, dass die Frequenzänderung $\beta$ für den betreffenden Impuls pro Zeiteinheit unendlich ist.

Wird beispielsweise der erste Hochfrequenzimpuls in der Amplitude moduliert, dann ergibt sich die erwünschte Kompensation der Phasenverschiebung, wenn zumindest die Gradienten $g_2$ und $g_3$ während des zweiten und des dritten Hochfrequenzimpulses einander gleich sind und die Frequenzänderungen pro Zeiteinheit $\beta_2$ und $\beta_3$ die gleiche Grösse aber entgegengesetzte Vorzeichen haben, d.h. wenn die Frequenz sich während der Impulse mit der gleichen Geschwindigkeit ändert, beim einen Impuls jedoch zunimmt und beim anderen abnimmt.

Wird stattdessen der dritte (oder der zweite Impuls) in der Amplitude moduliert, dann ergibt sich die erwünschte Kompensation der Phasenverschiebungen, wenn sowohl die Gradienten $g_1$, $g_2$ als auch die Frequenzänderungen pro Zeiteinheit $\beta_1$ und $\beta_2$ gleich gross sind.

## Ansprüche

1. Verfahren zur Ermittlung einer Kernmagnetisierungsverteilung in einem Teil eines Körpers, bei dem ein stationäres homogenes Magnetfeld erzeugt wird, in dem sich der Teil des Körpers befindet und bei dem

a) elektromagnetische Hochfrequenzimpulse zum Erzeugen eines Kernspinresonanzsignals erzeugt werden,

b) nach einer Vorbereitungszeit während einer Messzeit durch Abtastung eine Gruppe von Signalproben des Resonanzsignals genommen wird,

c) nach einer Wartezeit stets die Schritte a) und b) einige Male zum Erhalten verschiedener (n') Gruppen von je (n) Signalproben wiederholt werden, aus denen nach einer Signaltransformation ein Bild der erzeugten Kernmagnetisierungsverteilung bestimmt wird, wobei die elektromagnetischen Hochfrequenzimpulse frequenzmodulierte Impulse sind, dadurch gekennzeichnet, dass die auf die Zeiteinheit bezogene Änderung der Frequenz der Hochfrequenzimpulse so gewählt ist, dass die von den einzelnen Hochfrequenzimpulsen bewirkten Phasenverschiebungen von Kernspins einander kompensieren, und falls bei jedem Hochfrequenzimpuls ein Gradientenmagnetfeld angelegt ist, dann die von den einzelnen Hochfrequenzimpulsen bewirkten Phasenverschiebungen von unterschiedlichen Gradientenmagnetfeldern ausgesetzten Kernspins einander kompensieren.

2. Verfahren nach Anspruch 1, wobei das Kernspinresonanzsignal nach wenigstens zwei Hochfrequenzimpulsen aufgenommen wird, während denen jeweils ein magnetisches Gradientenfeld wirksam ist, dadurch gekennzeichnet, dass die Feldstärke der während der Hochfrequenzimpulse wirksamen Gradientenfelder und/oder die auf die Zeiteinheit bezogene Änderung der Frequenz der Hochfrequenzimpulse so gewählt ist, dass die von den einzelnen Impulsen bewirkten Phasenverschiebungen der Kernspins einander kompensieren.

3. Verfahren nach Anspruch 1 zum Aufnehmen von Spin-echosignalen, dadurch gekennzeichnet, dass während eines 90°-Impulses ein magnetisches Gradientenfeld eingeschaltet und während eines 180°-Impulses ein in gleicher Richtung verlaufendes magnetisches Gradientenfeld wirksam ist, und dass die Gradientenfelder bzw. die Frequenzänderungen pro Zeiteinheit so gewählt sind, dass die Beziehung

$$g_1^2 \, / \, \beta_1 \; = \; 2g_2^2 \, / \, \beta_2$$

erfüllt ist, wobei $g_1$, $g_2$ die Gradienten des magnetischen Gradientfeldes während des ersten bzw. des zweiten Hochfrequenzimpulses und $\beta_1$, $\beta_2$ die auf die Zeiteinheit bezogenen Frequenzänderungen während des ersten bzw. zweiten Hochfrequenzimpulses sind.

4. Verfahren nach Anspruch 2, dadurch gekennzeichnet, dass zum Aufnehmen von stimulierten Echosignalen mit zwei aufeinanderfolgenden 90°-Impulsen und wenigstens einem dritten Impuls währenddessen jeweils in gleicher Richtung verlaufende Gradientenfelder anliegen, die Gradientenfelder und die Frequenzmodulation der Impulse so gewählt sind, dass die Beziehung

$$g_1^2 \, / \, \beta_1 \; = \; g_2^2 \, / \, \beta_2 \; + \; g_3^2 \, / \, \beta_3$$

erfüllt ist, wobei $g_1$, $g_2$, $g_3$ den Gradienten des magnetischen Gradientenfeldes während des ersten, zweiten bzw. dritten Hochfrequenzimpulses und $\beta_1$, $\beta_2$, $\beta_3$ den auf die Zeiteinheit bezogenen Änderungen der Frequenz während des ersten, zweiten bzw. dritten Hochfrequenzimpulses entsprechen.

5. Verfahren nach Anspruch 3, dadurch gekennzeichnet, dass die Frequenzänderung des 180°-Hochfrequenzimpulses je Zeiteinheit etwa zweimal höher als die Frequenzänderung des 90°-Impulses ist, wobei beide Impulse nahezu den gleichen Frequenzhub aufweisen.

6. Verfahren nach Anspruch 5, dadurch gekennzeichnet, dass die Amplitude des 180°-Impulses zumindest zweimal grösser als die Amplitude des 90°-Impulses ist.

7. Verfahren nach Anspruch 5, dadurch gekennzeichnet, dass das während des 90°-Impulses vorhandene Gradientenmagnetfeld eine Stärke hat, die um den Faktor Wurzel zwei grösser als die Stärke des beim 180°-Impuls angelegten Gradientenmagnetfelds ist.

8. Verfahren nach Anspruch 1, dadurch gekennzeichnet, dass nach dem Erzeugen eines ersten Kernspinechosignals zumindest ein weiteres Kernspinechosignal erzeugt wird mit zumindest einem zusammengesetzten 180°-Hochfrequenzimpuls, und dass der zusammengesetzte 180°-Hochfrequenzimpuls aus einer ungeraden Anzahl von 180°-Impulsen zusammengesetzt ist, deren Summe der quadratischen Beiträge in der Dephasierung der Kernspins gleich Null ist.

9. Verfahren nach Anspruch 8, dadurch gekennzeichnet, dass der zusammengesetzte 180°-Impuls aus drei 180°-Impulse besteht, wobei die Frequenzänderung des ersten und des dritten 180°-Impulses je Zeiteinheit zweimal so gross wie die Frequenzänderung des zweiten 180°-Impulses je Zeiteinheit ist und die drei 180°-Impulse je den gleichen Frequenzhub aufweisen.

10. Verfahren nach Anspruch 9, dadurch gekennzeichnet, dass die Amplitude des zweiten 180°-Impulses die Hälfte der Amplitude des ersten und des dritten 180°-Impulses beträgt.

11. Verfahren nach einem der Ansprüche 1-10, dadurch gekennzeichnet, dass das Frequenzspektrum des Hochfrequenzimpulses nahezu eine Rechteckform mit Vorder- und Rückflanken hat, die von einer Gaussischen Kurve bestimmt sind.

12. Kernspinresonanzgerät zur Durchführung des Verfahrens nach Anspruch 1, das die folgenden Mittel enthält:
a) Mittel zum Erzeugen eines stationären homogenen Magnetfelds,
b) einen Hochfrequenzoszillator und eine Hochfrequenzspule zum Erzeugen elektromagnetischer frequenzmodulierter Hochfrequenzstrahlung, wobei die erzeugte Frequenz zeitabhängig ist,
c) Mittel zum Erzeugen eines Gradientenmagnetfeldes,
d) Abtastmittel zum Abtasten eines mit den unter a) und b) erwähnten Mitteln erzeugten Resonanzsignals,
e) Verarbeitungsmittel zum Verarbeiten der von den Abtastmitteln gelieferten Gruppen von Signalproben, wobei ein Bild einer Kernmagnetisierungsverteilung bestimmt wird, und
f) Steuermittel zum Steuern der unter b) bis e) erwähnten Mittel zum Erzeugen, Konditionieren, Abtasten und Verarbeiten der Signalprobengruppen, gekennzeichnet durch programmierte Mittel zum Einstellen der auf die Zeiteinheit bezogenen Änderung der Frequenz der nacheinanderfolgenden Hochfrequenzimpulse und/oder der Stärke des gegebenenfalls während der Hochfrequenzimpulse vorhandenen Gradientenmagnetfeldes zur Kompensation der von den einzelnen Hochfrequenzimpulsen bewirkten Phasenverschiebungen von Kernspins.

## Claims

1. A method of determining a nuclear magnetization distribution in a region of a body which is situated in a generated steady, uniform magnetic field, where:
a) electromagnetic r.f. pulses are generated in order to generate a nuclear spin resonance signal,
b) after a preparation period, a group of signal samples of the nuclear spin resonance signal are taken by sampling during a measurement period,
c) each time after a waiting period, the steps a) and b) are repeated a number of times in order to obtain several (n') groups of (n) signal samples each wherefrom, after signal transformation, an image of the nuclear magnetization distribution produced is determined, the electromagnetic r.f. pulses being frequency modulated pulses, characterized in that the variation of the frequency of the r.f. pulses as function of the unit of time is chosen so that the phase shifts of nuclear spins, caused by the individual r.f. pulses, compensate for one another and that, if a gradient magnetic field is applied for each r.f. pulse, the phase shifts, caused by the individual r.f. pulses, of nuclear spins subjected to different gradient magnetic fields compensate for one another.

2. A method as claimed in Claim 1, where the spin resonance signal is detected after at least two r.f. pulses during which a respective magnetic gradient field is active, characterized in that the field strength of the gradient fields active during the r.f. pulses and/or the variation of the frequency of the r.f. pulses as a function of the unit of time is chosen so that the phase shifts of the nuclear spins, caused by the individual pulses, compensate for one another.

3. A method as claimed in Claim 1 for the detection of spin echo signals, characterized in that a gradient magnetic field is active during a 90$^{\circ}$ pulse and that during a 180$^{\circ}$ pulse a gradient magnetic field which extends in the same direction is active, the gradient fields or the frequency variations per unit of time being chosen so that the relation

$$g_1^2 \,/\, \beta_1 \;=\; 2 g_2^2 \,/\, \beta_2$$

is satisfied, where $g_1$, $g_2$ are the gradients of the gradient magnetic field during the first and the second r.f. pulse, respectively, and $\beta_1$, $\beta_2$ are the frequency variations as a function of the unit of time during the first and the second r.f. pulse, respectively.

4. A method as claimed in Claim 2, characterized in that for the detection of stimulated echo signals by means of two successive 90$^{\circ}$ pulses and at least one third pulse during which gradient fields extending in the same direction are applied, the gradient fields and the frequency modulation of the pulses are chosen so that the relation

$$g_1^2 \,/\, \beta_1 \;=\; g_2^2 \,/\, \beta_2 \;+\; g_3^2 \,/\, \beta_3$$

is satisfied, where $g_1$, $g_2$, $g_3$ correspond to the gradients of the magnetic gradient field during the first, the second and the third r.f. pulse, respectively, and $\beta_1$, $\beta_2$, $\beta_3$ correspond to the variations of the frequency as a function of the unit of time during the first, the second and the third r.f. pulse, respectively.

5. A method as claimed in Claim 3, characterized in that the frequency variation of the 180$^{\circ}$ r.f. pulse per unit of time amounts to approximately twice the frequency variation of the 90$^{\circ}$ pulse, both pulses having approximately the same frequency swing.

6. A method as claimed in Claim 5, characterized in that the amplitude of the 180$^{\circ}$ pulse amounts to at least twice the amplitude of the 90$^{\circ}$ pulse.

7. A method as claimed in Claim 5, characterized in that the gradient magnetic field active during the 90$^{\circ}$ pulse has a strength which is a factor 2 greater than the strength of the gradient magnetic field applied during the 180$^{\circ}$ pulse.

8. A method as claimed in Claim 1, characterized in that, subsequent to the generating of a first spin echo signal, at least one further spin echo signal is generated by means of at least one composite 180$^{\circ}$ r.f. pulse, the composite 180$^{\circ}$ r.f. pulse being composed of an odd number of 180$^{\circ}$ pulses whose summed squarelaw contribution to the dephasing of the nuclear spins equals zero.

9. A method as claimed in Claim 8, characterized in that the composite 180$^{\circ}$ pulse consists of three 180$^{\circ}$ pulses, the frequency variation of the first and the third 180$^{\circ}$ pulse per unit of time amounting to twice the frequency variation of the second 180$^{\circ}$ pulse per unit of time, the three 180$^{\circ}$ pulses having the same frequency swing.

10. A method as claimed in Claim 9, characterized in that the amplitude of the second 180$^{\circ}$ pulse amounts to half the amplitude of the first and the third 180$^{\circ}$ pulse.

11

**11.** A method as claimed in any one of the Claims 1 to 10, characterized in that the frequency spectrum of the r.f. pulse has an approximately rectangular shape with leading and trailing edges which are determined by a gaussion curve.

**12.** A nuclear magnetic resonance apparatus for performing the method claimed in Claim 1, comprising the following means:

a) means for generating a steady, uniform magnetic field,

b) an r.f. oscillator and an r.f. coil for generating electromagnetic frequency modulated r.f. radiation, the frequency generated being time-dependent,

c) means for generating a gradient magnetic field,

d) sampling means for sampling a resonance signal generated by the means specified in a) and b),

e) processing means for processing the groups of signal samples supplied by the sampling means, an image of a nuclear magnetization distribution thus being determined, and

f) control means for controlling the means specified in b) to e) for generating, conditioning, sampling and processing the groups of signal samples, characterized in that it comprises programmed means for adjusting the variation as a function of unit of time of the frequency of the successive r.f. pulses and/or the strength of the gradient magnetic field possibly present during the r.f. pulses in order to compensate for the phase shifts of nuclear spins caused by the individual r.f. pulses.

**Revendications**

**1.** Procédé pour déterminer une distribution de la magnétisation nucléaire dans une région d'un corps, selon lequel on produit un champ magnétique homogène constant, dans lequel se trouve la région du corps et selon lequel

a) on produit des impulsions électromagnétiques de haute fréquence en vue d'engendrer un signal de résonance magnétique nucléaire,

b) après une période de préparation, pendant un temps de mesure, on prélève, par échantillonnage, un groupe d'échantillons de signal du signal de résonance,

c) après une période d'attente, on répète toujours quelques fois les opérations a) et b) pour obtenir plusieurs (n') groupes comprenant chacun (n) échantillons de signal, à partir desquels, après une transformation de signal, on établit une image de la distribution de la magnétisation nucléaire produite, les impulsions électromagnétiques de haute fréquence étant des impulsions modulées en fréquence, caractérisé en ce que la variation de la fréquence des impulsions haute fréquence par rapport à l'unité de temps est choisie telle que les déphasages des spins nucléaires provoqués par les impulsions haute fréquence individuelles se compensent mutuellement et que, dans le cas où un champ magnétique de gradient est appliqué à chaque impulsion haute fréquence, les déphasages provoqués par les impulsions haute fréquence individuelles de spins nucléaires exposés à des champs magnétiques de gradients différents se compensent mutuellement.

**2.** Procédé suivant la revendication 1, selon lequel le signal de résonance magnétique nucléaire est enregistré après au moins deux impulsions haute fréquence, pendant lesquelles un champ magnétique de gradient est chaque fois actif, caractérisé en ce que l'intensité de champ des champs de gradients actifs pendant les impulsions haute fréquence et/ou la variation de la fréquence des impulsions haute fréquence par unité de temps sont choisies telles que les déphasages des spins nucléaires provoqués par les impulsions individuelles se compensent mutuellement.

**3.** Procédé suivant la revendication 1 pour enregistrer des signaux d'écho de spin, caractérisé en ce que, pendant une impulsion à 90°, un champ magnétique de gradient est enclenché et pendant une impulsion à 180°, un champ magnétique de gradient s'étendant dans le même sens est actif, et que les champs de gradients ou les variations de fréquence par unité de temps sont choisis de telle façon que la relation

$$g_1^2/\beta_1 \;=\; 2g_2^2/\beta_2$$

soit satisfaite, $g_1$, $g_2$ étant respectivement les gradients des champs magnétiques de gradients pendant la première et la seconde impulsion haute fréquence et $\beta_1$, $\beta_2$, les variations de fréquence par unité de temps pendant la première et la seconde impulsion haute fréquence.

4. Procédé suivant la revendication 2, caractérisé en ce que, pour l'enregistrement de signaux d'écho stimulés à l'aide de deux impulsions à 90° successives et d'au moins une troisième impulsion pendant lesquelles des champs de gradients s'étendant dans le même sens sont chaque fois présents, les champs de gradients et la modulation de fréquence des impulsions sont choisis tels que la relation

$$g_1^2/\beta_1 \;=\; g_2^2/\beta_2 \;+\; g_3^2/\beta_3$$

soit satisfaite, $g_1$, $g_2$, $g_3$ étant respectivement les gradients des champs magnétiques de gradients pendant la première, la deuxième et la troisième impulsion haute fréquence et $\beta_1$, $\beta_2$, $\beta_3$ correspondant respectivement aux variations de la fréquence par unité de temps pendant la première, la deuxième et la troisième impulsion haute fréquence.

5. Procédé suivant la revendication 3, caractérisé en ce que la variation de fréquence par unité de temps de l'impulsion haute fréquence à 180° correspond approximativement au double de la variation de la fréquence pour l'impulsion à 90°, ces deux impulsions présentant à peu près la même excursion de fréquence.

6. Procédé suivant la revendication 5, caractérisé en ce que l'amplitude de l'impulsion à 180° correspond au moins au double de l'amplitude de l'impulsion à 90°.

7. Procédé suivant la revendication 5, caractérisé en ce que le champ magnétique de gradient présent pendant l'impulsion à 90° a une intensité qui est supérieure du facteur $\sqrt{2}$ à l'intensité du champ magnétique de gradient présent pendant l'impulsion à 180°.

8. Procédé suivant la revendication 1, caractérisé en ce qu'après la production d'un premier signal d'écho de spins nucléaires, au moins un autre signal d'écho de spins nucléaires est produit à l'aide d'au moins une impulsion haute fréquence à 180° composée et que l'impulsion haute fréquence à 180° composée est composée d'un nombre impair d'impulsions à 180°, dont la somme des contributions quadratiques au déphasage des spins nucléaires est égale à zéro.

9. Procédé suivant la revendication 8, caractérisé en ce que l'impulsion à 180° composée est composée de trois impulsions à 180°, la variation de fréquence par unité de temps de la première et de la troisième impulsion à 180° correspondant au double de la variation de fréquence par unité de temps de la deuxième impulsion à 180° et les trois impulsions à 180° présentant chaque fois la même excursion de fréquence.

10. Procédé suivant la revendication 9, caractérisé en ce que l'amplitude de la deuxième impulsion à 180° correspond à la moitié de l'amplitude de la première et de la troisième impulsion à 180°.

11. Procédé suivant l'une quelconque des revendications 1 à 10, caractérisé en ce que le spectre de fréquences de l'impulsion haute fréquence est approximativement de forme rectangulaire à flancs antérieurs et postérieurs qui sont déterminés par une courbe de Gauss.

12. Appareil à résonance magnétique nucléaire pour l'exécution du procédé suivant la revendication 1, qui comprend les moyens suivants :
    a) un moyen pour produire un champ magnétique homogène constant,
    b) un oscillateur haute fréquence et une bobine haute fréquence pour produire un rayonnement haute fréquence électromagnétique modulé en fréquence, la fréquence produite étant fonction du temps,
    c) un moyen pour produire un champ magnétique de gradient,
    d) un moyen d'échantillonnage pour échantillonner un signal de résonance produit par les moyens cités sous a) et b),
    e) un moyen de traitement pour traiter les groupes d'échantillons de signal fournis par le moyen d'échantillonnage de manière à établir une image d'une distribution de la magnétisation nucléaire, et
    f) un moyen de commande pour commander les moyens cités sous b) à e) pour engendrer,

13

conditionner, échantillonner et traiter les groupes d'échantillons de signal, caractérisé par des moyens programmés pour régler la variation par unité de temps de la fréquence des impulsions haute fréquence successives et/ou l'intensité du champ magnétique de gradient éventuellement présent pendant les impulsions haute fréquence en vue de la compensation des déphasages des spins nucléaires provoqués par les impulsions haute fréquence individuelles.

FIG.1

FIG.2

FIG. 3

FIG. 4

FIG. 5